(19) Europäisches Patentamt
European Patent Office
Office européen des brevets

(11) **EP 2 131 357 A1**

(12) **DEMANDE DE BREVET EUROPEEN**

(43) Date de publication:
**09.12.2009 Bulletin 2009/50**

(51) Int Cl.:
***G10L 21/02*** *(2006.01)*

(21) Numéro de dépôt: **09290326.9**

(22) Date de dépôt: **06.05.2009**

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **04.06.2008 FR 0803087**

(71) Demandeur: **Parrot**
**75010 Paris (FR)**

(72) Inventeurs:
• **Hoang Co Thuy, Vu**
**77330 Ozoir la Ferriere (FR)**
• **Pochon, Benoit**
**75010 Paris (FR)**

(74) Mandataire: **Dupuis-Latour, Dominique**
**Bardehle Pagenberg Dost Altenburg Geissler**
**10, boulevard Haussmann**
**75009 Paris (FR)**

(54) **Système de contrôle automatique du gain appliqué à un signal audio en fonction du bruit ambiant**

(57)    Système (100) de contrôle automatique du gain appliqué à un signal audio ($S_a$) en fonction du bruit ambiant, comprenant : un module (110) d'estimation de bruit ambiant, apte à établir une valeur de bruit courant (*noise*) estimée à partir, au moins, d'un signal ($S_m$) fourni par un microphone (50) ; et un module (120) de contrôle automatique de gain, apte à appliquer au signal audio ($S_a$) une valeur de gain déterminée en fonction de la valeur de bruit courant (*noise*) reçue du module (110) d'estimation de bruit ambiant. Selon l'invention, le module (110) d'estimation de bruit ambiant comprend un estimateur MCRA (111) apte à établir ladite valeur de bruit courant (*noise*) à partir d'un signal ($S_m$) fourni par le microphone (50) captant le bruit réel, l'écho de la musique et le cas échant la parole. Le système comprend également un module (130) d'estimation de la puissance du signal audio, apte à fournir au module (120) de contrôle automatique de gain une valeur de la puissance courante (*power*) du signal audio.

FIG_1

EP 2 131 357 A1

**Description**

L'invention concerne un système de contrôle automatique du gain appliqué à un signal audio en fonction du bruit ambiant.

L'invention trouve une application particulièrement avantageuse dans le domaine des équipements audio, notamment les équipements audio à microphone intégré, comme les autoradios munis de la fonction de téléphonie "mains libres" le FR 2 890 513 A1 (Parrot) décrit un tel autoradio dont la façade inclut deux microphones permettant de capter la voix du conducteur, pour la conversation téléphonique et éventuellement pour des commandes vocales.

Dans ce contexte, l'invention a plus spécialement pour objectif d'améliorer l'écoute de programmes musicaux, qu'ils soient produits par une source de l'équipement audio en "streaming", par un signal appliqué sur l'entrée "line-in" de l'appareil ou des signaux de radiodiffusion.

On sait en effet que l'écoute de tels programmes par un utilisateur, qui peut être une personne présente dans un véhicule automobile équipé d'un autoradio "mains libres", est fortement influencée par le niveau sonore du bruit ambiant dans lequel se trouve cet utilisateur. Il est donc souhaitable de pouvoir adapter le volume sonore du signal audio utile à celui du bruit ambiant en l'augmentant, ou en le diminuant, automatiquement en fonction des variations correspondantes du bruit environnant.

À cet égard, la présence d'un microphone dans l'équipement audio se révèle particulièrement pertinente puisque, outre sa fonction première dédiée à la communication "mains libres", le microphone peut servir à une autre fonction, à savoir celle de mesurer le niveau et les variations du bruit ambiant afin d'en déduire automatiquement le gain à appliquer au signal audio et d'ajuster le volume utile à un niveau permettant d'assurer à l'utilisateur un même confort d'écoute quel que soit l'environnement sonore dans lequel il se trouve.

Cependant, l'utilisation d'un microphone comme capteur de bruit ambiant présente une difficulté liée au fait que le microphone est capable de capter également l'écho de la musique restituée par les haut-parleurs et la voix des personnes présentes dans le véhicule.

Or, ces deux derniers éléments ne doivent pas être considérés comme du bruit ambiant. On comprend que si, par exemple, le niveau de musique augmente dans le véhicule, la puissance du signal sonore capté par le microphone augmente en conséquence par effet d'écho. Si cette augmentation était considérée comme du bruit, le gain appliqué au signal audio serait lui-même augmenté, entraînant une augmentation simultanée du niveau de musique et donc à nouveau celle de la puissance de l'écho capté par le microphone. On aboutirait dans ce cas à une boucle divergente.

Il en est de même pour la voix des personnes. Si une conversation s'engage à bord du véhicule, l'augmentation correspondante de la puissance captée par le microphone ne doit pas être considérée comme une augmentation du bruit ambiant susceptible d'entraîner une augmentation automatique du gain du signal audio, car cette augmentation viendrait gêner la conversation (déjà perturbée par le bruit ambiant), ce qui serait contraire au but recherché.

S'agissant du problème lié à l'écho acoustique, on connaît de l'état de la technique des systèmes de contrôle automatique de volume permettant de l'éliminer du signal sonore capté par le microphone.

Par exemple, le US 6 868 162 A1 décrit un tel système de contrôle automatique de gain où le signal audio est traité par un filtre adaptatif, puis soustrait du signal détecté par le microphone, le signal d'erreur résultant fournissant une estimée du bruit ambiant.

Dans un autre système, proposé par le WO 01/89184 A1, l'estimation de la valeur de bruit courant est établie périodiquement, directement à partir du signal fourni par le microphone après soustraction du signal d'annulation d'écho.

On notera toutefois que la mise en oeuvre d'un annuleur d'écho exige des ressources de calcul importantes de la part du processeur de traitement du signal. Ainsi, le recours à un dispositif de ce type, bien que conduisant à une meilleure estimation du bruit ambiant, doit être considéré comme facultatif et réservé aux équipements disposant de ressources de calcul suffisantes.

S'agissant maintenant du problème lié à la voix des personnes, on constate aujourd'hui que l'état de la technique ne fournit pas de solution pour l'éliminer du signal sonore capté par le microphone.

Aussi, un but de l'invention est de proposer un système de contrôle automatique de gain qui permette d'extraire efficacement et simplement, à partir du signal détecté par le microphone, le signal de parole lié à la voix de personnes présentes dans le véhicule, et ainsi d'améliorer l'estimation du bruit ambiant servant de base au contrôle automatique de volume.

Ce but est atteint, conformément à l'invention, grâce à un système de contrôle automatique du gain appliqué à un signal audio en fonction du bruit ambiant, du type générique décrit par le WO 01/89184 A1 précité, comprenant : un module d'estimation de bruit ambiant, apte à établir une valeur de bruit courant estimée à partir, au moins, d'un signal fourni par un microphone ; et un module de contrôle automatique de gain, apte à appliquer audit signal audio une valeur de gain déterminée en fonction de la valeur de bruit courant reçue du module d'estimation de bruit ambiant.

Selon l'invention, le module d'estimation de bruit ambiant comprend un estimateur MCRA apte à établir ladite valeur de bruit courant à partir d'un signal fourni par le microphone captant le bruit réel, l'écho de la musique et le cas échant la parole, le système comprenant en outre un module d'estimation de la puissance du signal audio, apte à fournir au module de contrôle automatique de gain une valeur de la puissance courante du signal audio.

L'estimateur MCRA mis en oeuvre par l'invention est par exemple celui décrit dans le WO 2007/099222 A1 (Parrot) en tant que dispositif de traitement d'un signal audio pour l'élimination du bruit dans un signal audio bruité comportant une composante de parole combinée à une composante de bruit, le but étant d'obtenir un signal de parole exempt de bruit.

Cet estimateur s'appuie sur un algorithme connu sous l'acronyme MCRA (*Minima Controlled Recursive Averaging*) décrit dans l'article de I. Cohen et B. Berdugo, Noise Estimation by Minima Controlled Recursive Averaging for Robust Speech Enhancement, IEEE Signal Processing Letters, Vol. 9, No 1, pp 12-15, Jan. 2002.

Il est important de souligner que la présente invention utilise l'estimateur MCRA dans un but tout autre que celui d'éliminer le bruit d'un signal de parole, à savoir celui, au contraire, d'extraire le bruit ambiant d'un signal contenant un signal de parole.

En effet, le procédé de traitement décrit dans le WO 2007/099222 A1 précité comporte une étape intermédiaire d'estimation du bruit ambiant utilisant l'algorithme MCRA, le signal ainsi estimé pour le bruit ambiant étant soustrait du signal total pour en extraire le signal de parole. Cette étape est avantageusement mise à profit par le système de contrôle automatique de gain conforme à l'invention pour déterminer la seule composante de bruit ambiant après élimination de la composante de parole.

En ce qui concerne le module d'estimation de la puissance du signal audio, on verra en détail plus loin l'intérêt de cette disposition dans le cadre du traitement par le module de contrôle automatique de gain du signal de bruit ambiant, en l'absence de circuit d'annulation d'écho.

Avantageusement, le module d'estimation de bruit ambiant et le module d'estimation de la puissance du signal audio comprennent un filtre perceptif. Ceci permet de simuler au mieux la réponse en fréquence en fonction de la perception de l'utilisateur quant au bruit environnant.

Comme cela a été mentionné plus haut, il est possible d'obtenir une estimée encore plus précise du bruit ambiant si, selon l'invention, le module d'estimation de bruit ambiant comprend un circuit d'annulation de l'écho du signal audio présent dans le signal fourni par le microphone.

Concernant le contrôle automatique de gain proprement dit, selon l'invention le module de contrôle automatique de gain comprend : des moyens pour exécuter au préalable une étape d'initialisation en référence à un seuil minimum prédéterminé de bruit ambiant ; des moyens pour exécuter ensuite une étape de changement de gain ; et des moyens pour appliquer au signal audio la valeur de gain établie à l'issue de l'étape de changement de gain.

Ladite étape d'initialisation comprend :

- une étape de démarrage du procédé, consistant à estimer une valeur du bruit courant et à exécuter l'étape suivante de détermination d'un bruit de référence dès qu'une valeur de bruit courant est supérieure audit seuil de bruit ; et
- une étape de détermination d'un bruit de référence pour le changement de gain, consistant à établir une valeur de référence pour le bruit ambiant si la valeur de bruit courant est restée supérieure au seuil de bruit ambiant pendant une première durée déterminée, l'étape d'initialisation étant reprise dès qu'une valeur de bruit courant devient inférieure au seuil de bruit.

Ladite étape de changement de gain consiste à :

- calculer la différence entre la valeur de bruit et ladite valeur de référence de bruit ambiant ;
- appliquer au gain une variation établie en fonction de ladite différence, lorsque ladite différence reste supérieure, respectivement inférieure, à un seuil de changement de gain pendant une deuxième durée déterminée ; et
- établir une nouvelle valeur de référence pour le bruit ambiant, et reprendre l'étape de changement de gain, ladite étape de changement de gain étant interrompue avec application d'une diminution de gain dès qu'une valeur de bruit courant devient inférieure au seuil de bruit.

Enfin, l'invention concerne également un équipement audio comprenant une source de signal audio et un microphone, cet équipement comprenant un système de contrôle automatique de gain tel qu'exposé ci-dessus.

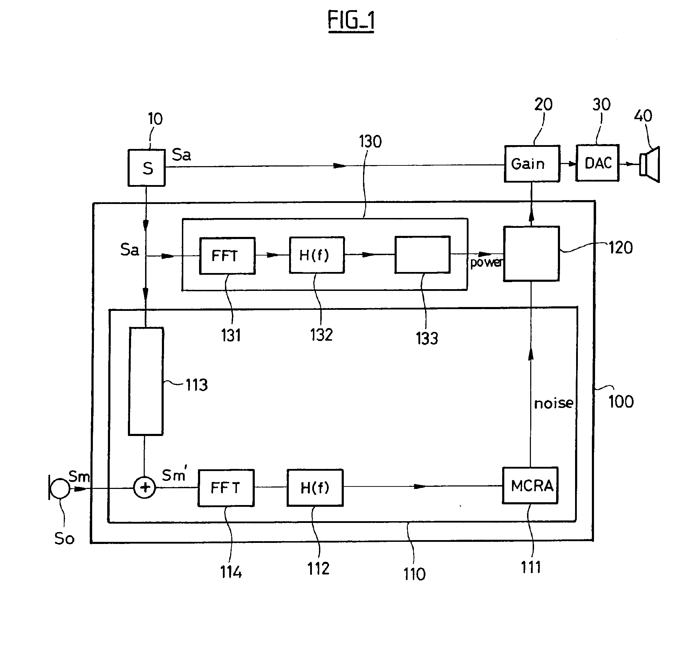

On va maintenant décrire un exemple de mise en oeuvre du dispositif de l'invention, en référence à la Figure 1 annexée, qui est un schéma d'un équipement audio comportant un système de contrôle automatique de gain selon l'invention.

Sur la Figure 1 est représenté un équipement audio, par exemple un autoradio comportant une fonctionnalité de communication "mains libres". À ce titre, l'équipement audio de la figure 1 comprend un microphone 50 dont la fonction première est de permettre la communication "mains libres".

L'équipement audio de la figure 1 comprend en outre une source 10 apte à fournir un signal audio numérique $S_a$ par radiodiffusion ou par tout autre moyen de diffusion, par exemple par "streaming" ou par un signal appliqué sur l'entrée "line-in" de l'appareil. Un amplificateur 20 à gain variable permet à un utilisateur de régler le volume du signal en sortie d'un ou plusieurs haut-parleurs 40 après conversion par un convertisseur numérique/analogique 30.

On peut voir sur la figure 1 que l'équipement audio comporte également un système 100 de contrôle automatique du gain de l'amplificateur 20 en fonction du bruit ambiant. On rappelle que le bruit ambiant dont il est question ici est le bruit détecté par le microphone 50 dont sont extraits le signal de parole, relatif à la voix des personnes présentes dans l'habitacie d'un véhicule par exemple, ainsi que l'écho du signal fourni par les haut-parleurs 40 et capté par le microphone 50. Toutefois, l'annulation de l'écho acoustique doit être considérée comme optionnelle du fait qu'elle dépend fortement des ressources en calcul du processeur de l'équipement audio.

Comme le montre la figure 1, le système 100 de contrôle automatique comprend un module 110 d'estimation de bruit ambiant dont le rôle est d'établir une valeur *noise* de bruit courant estimée à partir du signal $S_m$ fourni par le microphone 50. Cette valeur *noise* de bruit courant est transmise à un module 120 de contrôle automatique de gain qui détermine en conséquence la valeur du gain que doit appliquer l'amplificateur 20 au signal audio $S_a$ pour maintenir un confort d'écoute satisfaisant, quel que soit le niveau de bruit ambiant.

Selon le mode de réalisation de la figure 1, le module 110 d'estimation de bruit ambiant comprend un estimateur MCRA 111 destiné à fournir une valeur du bruit courant *noise* contenu dans le signal $S_m$ capté par le microphone 50. Afin de réaliser l'estimateur MCRA, le signal $S_m$ capté par le microphone 50 est, de manière classique, traité par un étage 114 de calcul d'une transformée de Fourier sur chaque trame du signal microphone $S_m$, de 20 ms de durée par exemple.

Dans l'exemple particulier de la figure 1, le signal $S_m$' résulte du traitement du signal $S_m$ par un circuit 113 d'annulation de l'écho du signal audio $S_a$ présent dans le signal $S_m$. Bien que fortement recommandée, la présence de ce circuit 113 dans le module 110 d'estimation de bruit ambiant reste néanmoins facultative et ne peut être envisagée que si les ressources de calcul de l'équipement audio le permettent, comme cela a été mentionné plus haut.

Un estimateur MCRA est décrit dans le WO 2007/099222 A1 précité et dans l'article également précité de I. Cohen et B. Berdugo.

Le module 110 d'estimation de bruit ambiant comporte en outre, en amont de l'estimateur MCRA 111, un filtre perceptif 112 défini de manière à tenir compte dans l'estimation du bruit ambiant de la réponse fréquentielle perceptive de l'utilisateur. Ce filtre est appliqué après estimation du spectre par la transformée de Fourier du module 114.

On peut voir sur la figure 1 que le système 100 de contrôle automatique de gain comprend également un module 130 d'estimation de la puissance du signal audio, apte à fournir au module 120 de contrôle automatique de gain une valeur *power* de la puissance courante du signal audio $S_a$. On verra plus loin l'intérêt de ce module d'estimation de puissance, en l'absence de circuit d'annulation d'écho acoustique.

Le module 130 d'estimation de puissance du signal audio $S_a$ comporte, de manière classique, un étage 131 de calcul d'une transformée de Fourier sur chaque trame du signal audio $S_a$, de 20 ms par exemple, et un étage 133 de calcul de la puissance en dB effectué en faisant la somme des composantes au carré du spectre en fréquence du signal. On observera également sur la figure 1 la présence entre les étages 131 et 133 d'un filtre perceptif 132 analogue au filtre perceptif 112, ceci afin d'appliquer la même loi de perception de l'utilisateur aux modules d'estimation de bruit ambiant et d'estimation de puissance du signal audio.

La valeur du gain à appliquer au signal audio par l'amplificateur 20 en fonction du bruit ambiant est déterminée par le module 120 de contrôle automatique de gain selon des modalités caractérisées par deux grandes étapes, à savoir une étape (1) d'initialisation et une étape (2) de changement de gain, détaillées ci-dessous en métalangage :

(1) <u>Étape d'initialisation</u>

(1 a) Étape de démarrage

```
if (noise≥init_thres), ref_noise=noise, wait 2 s, count=0, goto (1b)
else wait 2s, goto (1a)
```

(1 b) Étape de détermination d'un bruit de référence

```
if (noise<init-thres), wait 2 s, goto (1a)
if (|noise-ref_noise| ≥init_dyn _thres), ref_noise=noise, wait 2 s,
count=0, goto (1b)
else count++,
if (count ==Nb_count), make_ref, wait 2 s, Power_count=0, goto (2)
```

```
else wait 2s, goto (1 b)
```

(2) <u>Étape de changement de gain</u>

```
if (Power_comp), Power_count++
if Power_count==Nb_Power_count, wait 4 s, goto (3)
if (noise<init_thres), apply_gain, wait 4 s, goto (3)
else if ((noise-Ref_Noise))>thres_hi), hi_count++, lo_count=0
else if ((noise-Ref_Noise)<thres_lo), lo_count++, hi_count=0
else hi_count=0, lo_count=0
if (lo_count==Nb_lo_count) or (hi_count==Nb_hi_count),
apply_gain, wait 4 s, goto (3)
else Power_count=0, wait 2s, goto (2)
```

(3) <u>Étape finale</u>

```
if (noise≥init_thres), make_ref, Power_count=0, wait 2s, goto (2)
else wait 2s, goto (1a)
```

L'étape (1) d'initialisation est celle qui est exécutée systématiquement dès que le système de contrôle automatique de gain est activé, à la mise en marche de l'équipement audio par exemple.

Cette étape d'initialisation est elle-même composée de deux étapes, une étape (1a) de démarrage et une étape (1 b) de détermination d'une référence de bruit par rapport à laquelle seront établies les conditions de changement de gain lors de l'exécution de l'étape (2).

L'étape (1a) de démarrage a pour but de déclencher le contrôle automatique de volume uniquement si le niveau de bruit détecté est supérieur à un certain seuil. Une des justifications pour ce choix est que l'on souhaite éviter un changement de volume lorsque, par exemple, l'utilisateur se déplace en ville dans des conditions où le bruit est généralement faible mais varie en permanence du fait des démarrages ou des ralentissements liés au trafic.

La valeur courante du bruit courant *noise*, fournie par l'estimateur 111, est donc comparée par le module 120 de contrôle automatique de gain, toutes les 2 secondes par exemple, à un seuil de bruit minimum *init_thres* prédéterminé. L'étape (1 b) suivante n'est engagée que si la condition *noise≥int_thres* est réalisée. Dans ce cas, une valeur de référence temporaire de bruit *Ref_Noise* est prise égale à la valeur de bruit courant *noise.*

Comme cela a été mentionné plus haut, l'étape (1 b) de changement de gain a notamment pour but de définir une valeur de référence *Ref_Noise* pour le bruit ambiant, par rapport à laquelle les changements de volume seront ajustés lors de l'étape (2).

On vérifie d'abord, et ceci de manière systématique, que le bruit courant *noise* reste au moins égal au seuil *init_thres.* Si cette condition n'est pas vérifiée, l'étape (1a) de démarrage est reprise après un délai de 2 secondes par exemple.

Si, en revanche, la condition est vérifiée, on impose alors une nouvelle condition qui consiste à s'assurer que le bruit courant *noise* ne varie pas d'une valeur trop grande par rapport à la référence temporaire de bruit *ref_noise* pendant une durée assez longue : cette variation, positive ou négative, ne doit pas excéder un certain seuil (cf. étape 1.b, qui utilise sur la valeur absolue de la différence : si le bruit courant *noise* est trop grand ou trop petit, l'algorithme réagit de la même manière).

On évite ainsi de prendre en compte des situations d'augmentations (ou diminutions) de bruit ambiant trop fortes ou ponctuelles. C'est le cas en particulier où, en l'absence d'annulation d'écho acoustique, la musique elle-même pourrait être détectée comme du bruit, au démarrage d'un programme musical par exemple.

Si la valeur absolue |*noise-ref_noise* | est supérieure ou égale à un seuil dynamique de bruit *init_dyn_thres* déterminé, l'étape (1 b) est reprise après un délai de 2 secondes par exemple. Dans le cas contraire, on incrémente (opération "count++") un compteur *count,* lequel est comparé à un seuil de comptage *Nb_count.*

Si *count* est inférieur à *Nb_count*, l'étape (1 b) est reprise après un délai de 2 secondes par exemple.

Si le compteur *count* est égal à *Nb_count*, cela veut dire que les conditions précédentes concernant l'établissement (opération "make_ref") d'un bruit de référence *Ref_Noise* sont vérifiées pendant une durée assez longue égale à *x\*(Nb_count*-1) secondes, *x* étant la durée du délai, à savoir 2 secondes dans l'exemple plus haut.

L'opération "make_ref" correspond au calcul de la valeur de référence *Ref_Noise* pour le bruit ambiant, ce calcul étant effectué en prenant la valeur de bruit courant *noise* lissée par un filtre d'ordre 1. Plus précisément, si *noise*

($n$) est la valeur de bruit courant à l'instant $n$, alors on calcule en permanence une valeur lissée du bruit, selon la formule :

$$Smooth\_Noise(n) = \alpha.Smooth\_Noise(n\text{-}1) + (1\text{-}\alpha).noise(n)$$

où $\alpha$ est un coefficient de pondération ajustable inférieur ou égal à 1.

L'opération "make_ref" consiste à appliquer :

$$Ref\_Noise = Smooth\_Noise$$

Cette opération "make_ref" permet également de calculer une valeur de référence $Ref\_Power$ pour la puissance du signal audio $S_a$ d'une manière équivalente au calcul du bruit de référence. Si $Power(n)$ est la valeur de la puissance courante estimée à l'instant $n$ par le module 130, on calcule en permanence la valeur de la puissance lissée, filtrée à l'ordre 1, par la formule :

$$Smooth\_Power(n) = \beta.Smooth\_Power(n\text{-}1) + (1\text{-}\beta).noise(n)$$

où $\beta$ est un coefficient de pondération ajustable inférieur ou égal à 1.

L'opération "make_ref" consiste alors à appliquer :

$$Ref\_Power = Smooth\_Power$$

L'étape (2) de changement de gain est celle où, à proprement parler, le gain est appliqué au signal audio $S_a$ en fonction des variations du bruit ambiant.

Comme cela a été expliqué plus haut, l'écho du signal audio ne doit pas être interprété comme du bruit. C'est pourquoi en l'absence d'annulation d'écho, il est nécessaire d'empêcher l'application du gain si le signal a varié longtemps au-dessus d'un seuil. À cet effet, on calcule la valeur absolue $X$ de la différence entre la puissance estimée $power(m)$ à un instant $m$ et la dernière valeur de référence $Ref\_Power(n)$ calculée à l'instant $n<m$ :

$$X = \left| power(m) - Ref\_Power(n) \right|$$

Si $X$ est supérieur à un seuil $power\_dyn\_thres$ de dynamique de puissance, alors la condition "if (Power_comp)" est satisfaite et un compteur $Power\_count$ est incrémenté (opération "Power_count++"). Si ce compteur est égal à un seuil $Nb\_Power\_count$, cela veut dire que le signal a varié au-dessus d'un seuil maximum pendant une durée égale à $2.(Nb\_Power\_count\text{-}1)$ secondes. Alors, le déroulement de l'étape (2) est interrompu après 4 secondes par exemple pour exécuter l'étape (3) selon laquelle, si le bruit courant $noise$ est supérieur ou égal au seuil $init\_thres$, de nouvelles références sont établies (opération" make_ref") avec retour à l'étape (2) de changement de gain. Si le bruit courant $noise$ est inférieur au seuil $init\_thres$, l'étape (1) d'initialisation est reprise.

Dans le cas où le compteur $Power\_count$ est inférieur au seuil $Nb\_Power\_count,$ on vérifie que le bruit ambiant $noise$ est toujours supérieur ou égal au seuil minimal $init\_thres$. Si cette vérification est négative, une diminution de gain est appliquée relativement à la diminution de bruit constatée, l'étape (3) est exécutée après, par exemple, un délai de 4 s.

Si le bruit ambiant $noise$ est supérieur ou égal au seuil minimal $init\_thres$, on vérifie alors s'il a beaucoup varié par rapport au bruit de référence $Ref\_Noise$ déterminé lors de l'étape (1 b).

Si la différence du bruit ambiant $noise$ et du bruit de référence $Ref\_Noise$ est supérieure à un seuil $thres\_hi$ donné, on incrémente (opération "hi_count++") un compteur $hi\_count$.

De même, si la différence du bruit ambiant $noise$ et du bruit de référence $Ref\_Noise$ est inférieure à un seuil *thres_lo* donné, on incrémente (opération "lo_count++") un autre compteur *lo_count*.

Ensuite, chacun de ces compteurs est comparé à un seuil respectif, *Nb_hi_count* et *Nb_lo_count*. Si l'une des comparaisons est positive, cela veut dire que le bruit *noise* est resté suffisamment longtemps au-dessus ou au-dessous du bruit de référence *Ref_Noise* pour décider l'appliquer (opération "apply_gain") au signal audio un gain relatif à la différence de bruit constatée.

Le gain est modifié de la façon suivante.

Si le bruit courant *noise*(*m*) a augmenté de *x* dB par rapport au dernier bruit de référence *Ref_Noise*(*n*) (*m*>*n*), nn peut décider d'augmenter le gain de *x* dB également par défaut. Cependant, on peut faire varier ce facteur multiplicatif à volonté et augmenter le gain de 2.*x* dB par exemple.

Si le gain doit passer de *y* à *z* dB, cette augmentation peut être effectuée sur une seconde par exemple selon une progression linéaire dont la pente dépend de *y* et de *z*.

Si, au contraire, le bruit courant est inférieure au bruit de référence, le processus est le même, sauf que la pente de la courbe sera négative.

**Revendications**

1. Système (100) de contrôle automatique du gain appliqué à un signal audio ($S_a$) en fonction du bruit ambiant, comprenant :

   - un module (110) d'estimation de bruit ambiant, apte à établir une valeur de bruit courant (*noise*) estimée à partir, au moins, d'un signal ($S_m$) fourni par un microphone (50) ; et
   - un module (120) de contrôle automatique de gain, apte à appliquer au signal audio ($S_a$) une valeur de gain déterminée en fonction de la valeur de bruit courant (*noise*) reçue du module (110) d'estimation de bruit ambiant ;

   système **caractérisé :**

   - **en ce que** le module (110) d'estimation de bruit ambiant comprend un estimateur MCRA (111) apte à établir la valeur de bruit courant (*noise*) à partir d'un signal ($S_m$) fourni par le microphone (50) ;
   - et **en ce qu'**il comprend en outre un module (130) d'estimation de la puissance du signal audio, apte à fournir au module (120) de contrôle automatique de gain une valeur de la puissance courante (*power*) du signal audio.

2. Système selon la revendication 1, dans lequel le module (110) d'estimation de bruit ambiant et le module (130) d'estimation de la puissance du signal audio comprennent un filtre perceptif (112, 132).

3. Système selon la revendication 1, dans lequel le module (110) d'estimation de bruit ambiant comprend un circuit (113) d'annulation de l'écho du signal audio présent dans le signal ($S_m$) fourni par le microphone (50).

4. Système selon l'une des revendications 1 à 3, dans lequel le module (120) de contrôle automatique de gain comprend :

   - des moyens pour exécuter au préalable une étape 1) d'initialisation en référence à un seuil minimum prédéterminé de bruit ambiant (*init_thres*) ;
   - des moyens pour exécuter ensuite une étape 2) de changement de gain ; et
   - des moyens pour appliquer au signal audio la valeur de gain établie à l'issue de l'étape 2) de changement de gain,
   l'étape 1) d'initialisation comprenant :

      · une étape 1a) de démarrage du procédé consistant à estimer une valeur du bruit courant (*noise*), et à exécuter l'étape 1b) suivante de détermination d'un bruit de référence dès qu'une valeur de bruit courant (*noise*) est supérieure au seuil de bruit (*init_thres*), et
      · une étape 1 b) de détermination d'un bruit de référence pour le changement da gain, consistant à établir (make_ret) une valeur de référence (*Ref_Noise*) pour le bruit ambiant si la valeur de bruit courant (*noise*) est restée supérieure au seuil de bruit ambiant (*init_thres*) pendant une première durée déterminée, l'étape 1) d'initialisation étant reprise dès qu'une valeur de bruit courant (*noise*) devient inférieure au seuil de bruit (*init_thres*),

   ladite étape 2) de changement de gain consistant à :

. calculer la différence entre la valeur de bruit courant (*noise*) et la valeur de référence (*Ref_Noise*) de bruit ambiant,

. appliquer au gain (apply_gain) une variation établie en fonction de ladite différence, lorsque cette différence reste supérieure, respectivement inférieure, à un seuil (*thres_hi*, respectivement *thres_lo*), de changement de gain pendant une deuxième durée déterminée, et

. établir une nouvelle valeur de référence pour le bruit ambiant, et reprendre l'étape de changement de gain, et ladite étape 2) de changement de gain étant interrompue avec application d'une diminution de gain dès qu'une valeur de bruit courant (*noise*) devient inférieure au seuil de bruit (*init_thres*).

5. Système selon la revendication 4, dans lequel l'étape 1a) de démarrage consiste également à déterminer une valeur de référence temporaire de bruit (*ref_noise*), et dans lequel l'étape 1 b) de détermination d'un bruit de référence est interrompue dès que, pendant la première durée, la valeur absolue de la différence entre une valeur de bruit courant (*noise*) et la valeur de référence temporaire de bruit (*ref_noise*) est supérieure à un seuil de dynamique de bruit (*init_dyn_thres*).

6. Système selon la revendication 4, dans lequel l'étape 1b) de détermination d'un bruit de référence consiste également à déterminer une valeur de référence (*Ref_Power*) pour la puissance du signal audio, et dans lequel l'étape 2) de changement de gain est interrompue si la valeur absolue de la différence entre la valeur de puissance courante (*power*) du signal audio et la valeur de référence (*Ref_Power*) de puissance est restée supérieure à un seuil de dynamique de puissance (*power_dyn_thres*) pendant une troisième durée déterminée, avec retour à l'étape 2) de changement de gain si la valeur de bruit courant (*noise*) est supérieure au seuil de bruit (*init_thres*), ou à l'étape 1) d'initialisation dans le cas contraire.

7. Système selon la revendication 4, dans lequel la valeur de référence (*Ref_Noise*) de bruit ambiant est égale à la valeur de bruit courant (*noise*) lissée par un filtre d'ordre 1.

8. Système selon la revendication 6, dans lequel la valeur de référence (*Ref_Power*) de puissance du signal audio est égale à la valeur de puissance courante (*power*) du signal audio lissée par un filtre d'ordre 1.

9. Équipement audio comprenant une source de signal audio et un microphone, **caractérisé en ce qu'**il comprend en outre un système de contrôle automatique de gain selon l'une des revendications 1 à 8.

EP 2 131 357 A1

FIG_1

Europäisches
Patentamt

European
Patent Office

Office européen
des brevets

**RAPPORT DE RECHERCHE EUROPEENNE**

Numéro de la demande

EP 09 29 0326

| | DOCUMENTS CONSIDERES COMME PERTINENTS | | |
|---|---|---|---|
| Catégorie | Citation du document avec indication, en cas de besoin, des parties pertinentes | Revendication concernée | CLASSEMENT DE LA DEMANDE (IPC) |
| X | COHEN I; BERDUGO B: "Speech enhancement for non-stationary noise environments" SIGNAL PROCESSING, ELSEVIER SCIENCE PUBLISHERS B.V. AMSTERDAM, NL, vol. 81, no. 11, 1 novembre 2001 (2001-11-01), pages 2403-2418, XP004308517 ISSN: 0165-1684 * le document en entier * ----- | 1-9 | INV. G10L21/02 |
| X | NINGPING FAN; JUSTINIAN ROSCA; RADU BALAN: "Speech Noise Estimation Using Enhanced Minima Controlled Recursive Averaging" IEEE INTERNATIONAL CONFERENCE ON ACOUSTICS, SPEECH AND SIGNAL PROCESSING, ICASSP 2007, 15 - 20 APRIL 2007, HONOLULU, HAWAII, USA, PROCEEDINGS, 20070415 - 20070420 IEEE, US, 14 avril 2007 (2007-04-14), pages IV-581, XP002511252 ISBN: 978-1-4244-0728-6 * le document en entier * ----- | 1-9 | |
| X,D | EP 1 830 349 A1 (PARROT [FR]) 5 septembre 2007 (2007-09-05) * abrégé * * alinéas [0028], [0059], [0060] * ----- | 1-9 | DOMAINES TECHNIQUES RECHERCHES (IPC) G10L |
| A,D | ISRAEL COHEN; BARUCH BERDUGO: "Noise Estimation by Minima Controlled Recursive Averaging for Robust Speech Enhancement" IEEE SIGNAL PROCESSING LETTERS, IEEE SERVICE CENTER, PISCATAWAY, NJ, US, vol. 9, no. 1, 1 janvier 2002 (2002-01-01) , XP011059782 ISSN: 1070-9908 * le document en entier * ----- -/-- | 1-9 | |

Le présent rapport a été établi pour toutes les revendications

| Lieu de la recherche | Date d'achèvement de la recherche | Examinateur |
|---|---|---|
| La Haye | 25 août 2009 | Quélavoine, Régis |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

    ..............................................................................................
& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

EP 09 29 0326

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A,D | WO 01/89184 A1 (ERICSSON INC [US]; DENT PAUL W [US]; ROMESBURG ERIC DOUGLAS [US]) 22 novembre 2001 (2001-11-22) * abrégé; figures 3-8 * ----- | 1,3,9 | |

**DOMAINES TECHNIQUES RECHERCHES (IPC)**

Le présent rapport a été établi pour toutes les revendications

| Lieu de la recherche | Date d'achèvement de la recherche | Examinateur |
|---|---|---|
| La Haye | 25 août 2009 | Quélavoine, Régis |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

................................................................................

& : membre de la même famille, document correspondant

EPO FORM 1503 03.82 (P04C02)

**EP 2 131 357 A1**

**ANNEXE AU RAPPORT DE RECHERCHE EUROPEENNE
RELATIF A LA DEMANDE DE BREVET EUROPEEN NO.** EP 09 29 0326

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-08-2009

| Document brevet cité au rapport de recherche | | Date de publication | Membre(s) de la famille de brevet(s) | | Date de publication |
|---|---|---|---|---|---|
| EP 1830349 | A1 | 05-09-2007 | FR | 2898209 A1 | 07-09-2007 |
| | | | WO | 2007099222 A1 | 07-09-2007 |
| | | | US | 2007276660 A1 | 29-11-2007 |
| WO 0189184 | A1 | 22-11-2001 | AT | 306781 T | 15-10-2005 |
| | | | AU | 5927301 A | 26-11-2001 |
| | | | DE | 60113985 D1 | 17-11-2005 |
| | | | DE | 60113985 T2 | 29-06-2006 |
| | | | EP | 1282978 A1 | 12-02-2003 |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2890513 A1, Parrot
- US 6868162 A1
- WO 0189184 A1
- WO 2007099222 A1, Parrot

**Littérature non-brevet citée dans la description**

- **I. Cohen ; B. Berdugo.** Noise Estimation by Minima Controlled Recursive Averaging for Robust Speech Enhancement. *IEEE Signal Processing Letters,* Janvier 2002, vol. 9 (1), 12-15